(19) **Europäisches Patentamt**
**European Patent Office**
**Office européen des brevets**

(11) **EP 2 218 805 B1**

(12) # FASCICULE DE BREVET EUROPEEN

(45) Date de publication et mention
de la délivrance du brevet:
**14.03.2012 Bulletin 2012/11**

(51) Int Cl.:
***C25D 5/50*** *(2006.01)*    ***C30B 29/02*** *(2006.01)*
***C30B 33/00*** *(2006.01)*    ***C30B 33/02*** *(2006.01)*

(21) Numéro de dépôt: **10152945.1**

(22) Date de dépôt: **08.02.2010**

(54) **Procédé de cristallisation avec maîtrise de l'orientation des grains du cristal**

Kristallisierungsverfahren mit Kontrolle der Ausrichtung der Kristallkörner

Crystallisation method with control of the grain's direction in the crystal

(84) Etats contractants désignés:
**AT BE BG CH CY CZ DE DK EE ES FI FR GB GR HR HU IE IS IT LI LT LU LV MC MK MT NL NO PL PT RO SE SI SK SM TR**

(30) Priorité: **12.02.2009 FR 0950892**

(43) Date de publication de la demande:
**18.08.2010 Bulletin 2010/33**

(73) Titulaire: **Commissariat à l'Énergie Atomique et aux Énergies Alternatives**
**75015 Paris (FR)**

(72) Inventeur: **Sicardy, Olivier**
**38120 SAINT EGREVE (FR)**

(74) Mandataire: **Ilgart, Jean-Christophe**
**BREVALEX**
**95 rue d'Amsterdam**
**75378 Paris Cedex 8 (FR)**

(56) Documents cités:
**JP-A- 2 239 198**

• **BESSER P R ET AL: "MICROSTRUCTURAL CHARACTERIZATION OF INLAID COPPER INTERCONNECT LINES" JOURNAL OF ELECTRONIC MATERIALS, WARRENDALE, PA, US, vol. 30, no. 4, 1 avril 2001 (2001-04-01), pages 320-330, XP008006449 ISSN: 0361-5235**

• **REIMBOLD G ET AL: "Mechanical stress measurements in damascene copper interconnects and influence on electromigration parameters" IEEE XPLORE; [INTERNATIONAL ELECTRON DEVICES MEETING],, 8 décembre 2002 (2002-12-08), pages 745-748, XP010626148 ISBN: 978-0-7803-7462-1**

EP 2 218 805 B1

**Description**

L'invention concerne un procédé de cristallisation dont la propriété essentielle est que l'orientation des grains du cristal est maîtrisée.

L'orientation des grains du cristal se décide pendant sa croissance sous l'effet de phénomènes nombreux et complexes, qui dépendent d'ailleurs du procédé utilisé. Les propriétés des matériaux dépendant en général de l'orientation des grains, il peut être utile de maîtriser cette dernière. Cela concerne notamment les propriétés de conductivité électrique dans les couches minces de cuivre ou d'autres matières conductrices utilisées dans les circuits intégrés. De plus, il est souvent intéressant de maintenir une même orientation cristallographique des grains sur une grande étendue du cristal.

L'art antérieur comporte un certain nombre de travaux tentant d'élucider les mécanismes influençant l'orientation des cristaux, mais il ne semble pas qu'un procédé simple et général de maîtrise de l'orientation des grains ait été proposé dans le cas particulier de couches minces à la surface d'un substrat.

P. Besser et al. dans "Microstructural characterization of Inlaid copper Interconnect lines", J. of Electr. Mat., Vol 30 (2001) 320-330 décrit la recristallisation sous contrainte de ligne de cuivre pendant un recuit.

L'objet fondamental de l'invention est de combler cette lacune. Elle concerne un procédé de cristallisation conforme à la revendication.

L'invention sera décrite maintenant au moyen de la figure, qui représente le dispositif utilisé pour la mise en oeuvre du procédé. Il s'agit d'un four 1 incluant un banc de flexion 2. Un substrat 3 revêtu d'une couche 4 de la matière du cristal y est renfermé. Au sens de l' invention, une couche mince est d'épaisseur telle que les déformations parallèles à la surface du substrat 3 sont intégralement communiquées à ladite couche sur toute son épaisseur. Dans une première étape, le substrat 3 et la couche 4 sont chauffés à une température uniforme pendant une durée permettant de relâcher les contraintes internes de celle-ci, puisque ces contraintes internes perturberaient la mise en oeuvre du procédé et qu'elles sont généralement élevées à la suite des procédés de dépôt usuels. La température appliquée doit cependant laisser la matière de la couche 4 solide. Elle peut être d'environ 300°C pour les dépôts de cuivre électrolytique sur les substrats de silicium utilisés pour l'élaboration de circuits intégrés, et déterminée par calcul ou par des mesures par diffraction de rayons X.

Un écart de température, défini par rapport à la température précédente, est ensuite appliqué au substrat 3 et à la couche 4 en même temps qu'une flexion par le banc 2. Des contraintes d'origine double: flexion et dilatation thermique, apparaissent. Leurs effets dans la matière cristalline de la couche 4 vont maintenant être explicités au moyen de la mécanique des milieux continus.

On part de la relation (1) ε total = ε appliqué + ε élastique, qui exprime que, dans la couche 4, les déformations totales sont la somme des déformations appliquées par le milieu extérieur et de déformations élastiques internes. On obtient dans le cas d'un cristal cubique le système d'équations (2):

$$\begin{pmatrix} \beta_1 & 0 & 0 \\ 0 & \beta_2 & 0 \\ 0 & 0 & \beta \end{pmatrix} = \begin{pmatrix} \alpha & 0 & 0 \\ 0 & \alpha & 0 \\ 0 & 0 & \alpha \end{pmatrix} + \begin{pmatrix} \varepsilon_{11}^e & \varepsilon_{12}^e & \varepsilon_{13}^e \\ \varepsilon_{12}^e & \varepsilon_{22}^e & \varepsilon_{23}^e \\ \varepsilon_{13}^e & \varepsilon_{23}^e & \varepsilon_{33}^e \end{pmatrix}.$$

$$\underline{\underline{\varepsilon}}\ totales \qquad \underline{\underline{\varepsilon}}\ appliquées \qquad \underline{\underline{\varepsilon}}\ élastiques$$

dans le repère principal défini par les vecteurs $x_1$, $x_2$ et $x_3$, où $x_1$ est dans la longueur du substrat 3 (le long de la courbure appliquée), $x_2$ dans la largeur et $x_3$ est normal à la surface sur laquelle la couche 4 a été déposée. Les déformations totales comprennent trois composantes, dont les deux premières sont définies par les déformations sur la face supérieure du substrat 3 puisque le substrat 3, très épais par rapport à la couche 4, lui impose ses déformations, et sont reliés par l'équation:

$$(3) \qquad \beta_2 = -\nu\beta_1,$$

ν étant le coefficient de Poisson du substrat.
Les composantes α des déformations appliquées sont dues aux dilatations thermiques et dépendent des coefficients correspondants. La dilatation thermique du substrat 3 est négligée dans les calculs suivants, mais elle peut facilement être prise en compte par une modification des déformations totales, puisque cette dilatation thermique du substrat 3 revient à une condition aux limites. Par ailleurs, les composantes $\varepsilon_{ij}$ représentent les déformations élastiques de la couche 4.

On introduit maintenant un nouveau repère lié au cristal, formé de vecteurs $y_1$, $y_2$ et $y_3$, et des vecteurs q', q" et q qui sont des vecteurs unitaires identiques aux vecteurs $x_1$, $x_2$ et $x_3$, mais qui sont définis du point de vue de la couche 4. Les coordonnées des directions q, q' et q" dans le repère ($y_1$, $y_2$ $y_3$) sont notées $q_1$, $q_2$ et $q_3$; q'$_1$, q'$_2$ et q'$_3$; q"$_1$, q"$_2$, et q"$_3$ respectivement.

Dans le repère ($y_1$, $y_2$, $y_3$), les composantes $\varepsilon^e_{11}$, $\varepsilon^e_{22}$, $\varepsilon^e_{33}$, $\varepsilon^e_{33}$, $\varepsilon^e_{23}$, $\varepsilon^e_{13}$ et $\varepsilon^e_{12}$ de (2), exprimées en notation matricielle $e_1$ à $e_6$, valent :

$$(4) \qquad \begin{aligned} e_1 &= -\alpha + \beta_1 Q_1' + \beta_2 Q_1'' + \beta\, Q_1 \\ e_2 &= -\alpha + \beta_1 Q_2' + \beta_2 Q_2'' + \beta\, Q_2 \\ e_3 &= -\alpha + \beta_1 Q_3' + \beta_2 Q_3'' + \beta\, Q_3 \\ e_4 &= \qquad 2\beta_1 Q_4' + 2\beta_2 Q_4'' + 2\beta\, Q_4 \\ e_5 &= \qquad 2\beta_1 Q_5' + 2\beta_2 Q_5'' + 2\beta\, Q_5 \\ e_6 &= \qquad 2\beta_1 Q_6' + 2\beta_2 Q_6'' + 2\beta\, Q_6 \end{aligned}$$

avec $Q_1 = q_1^2$, $Q_2 = q_1^2$, $Q_3 = q_3^2$, $Q_4 = q_2\, q_3$, $Q_5 = q_3\, q_1$, $Q_6 = q_1\, q_2$, et de même pour les expressions des Q' et Q".

La loi de Hooke $\sigma = C\varepsilon$, générale et valide dans le domaine élastique des déformations, permet de déterminer le tenseur des contraintes et notamment le vecteur de contraintes $\sigma$ (q) qui s'applique sur la surface libre de la couche 4. Cela donne le système de composantes(5) exprimé dans le repère lié au cristal :

$$\begin{aligned} \text{selon } y_1 &: \left[-(C_{11} + 2\,C_{12})\alpha + (A\,Q_1 + C_{12})\,\beta + (A\,Q_1'' + C_{12})\,\delta + 2\,A\,q_1\,q_1''\,\gamma\right] q_1' \\ \text{selon } y_2 &: \left[-(C_{11} + 2\,C_{12})\alpha + (A\,Q_2 + C_{12})\,\beta + (A\,Q_2'' + C_{12})\,\delta + 2\,A\,q_2\,q_2''\,\gamma\right] q_2' \\ \text{selon } y_3 &: \left[-(C_{11} + 2\,C_{12})\alpha + (A\,Q_3 + C_{12})\,\beta + (A\,Q_3'' + C_{12})\,\delta + 2\,A\,q_3\,q_3''\,\gamma\right] q_3' \end{aligned}$$

Les composantes $C_{ij}$ sont celles du tenseur des constantes élastiques du cristal considéré:

$$(6) \qquad \begin{pmatrix} C_{11} & C_{12} & C_{12} & 0 & 0 & 0 \\ C_{12} & C_{11} & C_{12} & 0 & 0 & 0 \\ C_{12} & C_{12} & C_{11} & 0 & 0 & 0 \\ 0 & 0 & 0 & C_{44} & 0 & 0 \\ 0 & 0 & 0 & 0 & C_{44} & 0 \\ 0 & 0 & 0 & 0 & 0 & C_{44} \end{pmatrix}$$

Or les composantes du système (5) doivent toutes être nulles puisque la contrainte s'appliquant sur une surface libre l'est aussi. En ajoutant membre à membre ces composantes et en remarquant que les relations (7) :

$$Q_1 + Q_2 + Q_3 = 1, \quad Q_1' + Q_2' + Q_3' = 1 \quad \text{et} \quad Q_1'' + Q_2'' + Q_3'' = 1$$

s'appliquent, les vecteurs q, q' et q" étant normaux, on obtient finalement la relation (8):

$$-3(C_{11} + 2C_{12})\alpha + (A + 3C_{12})(\beta_1 + \beta_2) + (A + 3C_{12} + 6C_{44})\beta = 0$$

entre $\alpha$, $\beta_1$ et $\beta$, qui est indépendante du choix de q, q' et q".

En utilisant cette relation dans le repère lié au cristal, le système (5) de composantes devient le système (9):

$$\text{selon } y_1 \; : \; A\left[\left(Q_1' - \frac{1}{3}\right)\beta_1 + \left(Q_1^\cdot - \frac{1}{3}\right)\beta_2 + \left(Q_1 - \frac{1}{3}\right)\beta\right]q_1$$

$$\text{selon } y_2 \; : \; A\left[\left(Q_2' - \frac{1}{3}\right)\beta_1 + \left(Q_2^\cdot - \frac{1}{3}\right)\beta_2 + \left(Q_2 - \frac{1}{3}\right)\beta\right]q_2 \quad \text{avec} \quad \beta_2 = -\nu\beta_1$$

$$\text{selon } y_3 \; : \; A\left[\left(Q_3' - \frac{1}{3}\right)\beta_1 + \left(Q_3^\cdot - \frac{1}{3}\right)\beta_2 + \left(Q_3 - \frac{1}{3}\right)\beta\right]q_3$$

pour exprimer la contrainte s'appliquant sur la surface libre de la couche 4 avec $A = C_{11} - C_{12} - 2C_{44}$.

La condition de surface libre $\sigma$ (q)=0 est forcément respectée si le cristal est isotrope, puisque alors A=0. Les matériaux usuels cristallins possèdent cependant en pratique un degré d'anisotropie, de sorte que ce sont les quantités entre crochets du système (9) qui doivent être nulles.

L'utilisation des relations (7) permet de simplifier le système (9) et d'obtenir le système d'équations (10):

$$\begin{cases} \left(Q_1' - \frac{1}{3}\right)(\beta_1 - \beta_2) + \left(Q_1 - \frac{1}{3}\right)(\beta - \beta_2) = 0 \\[2mm] \left(Q_2' - \frac{1}{3}\right)(\beta_1 - \beta_2) + \left(Q_2 - \frac{1}{3}\right)(\beta - \beta_2) = 0 \\[2mm] \left(Q_3' - \frac{1}{3}\right)(\beta_1 - \beta_2) + \left(Q_3 - \frac{1}{3}\right)(\beta - \beta_2) = 0 \end{cases}$$

Il n'admet de solution que pour certaines valeurs de q et q' en raison des contraintes d'orthogonalité et de normalité des vecteurs. En d'autres termes, l'application d'une déformation de flexion au substrat 3 combinée à une déformation d'origine thermique de la couche 4 permet d'une part de limiter les orientations possibles du cristal et d'autre part de l'orienter en azimut puisque l'expression des coordonnées de q' est déterminée par celle de q.

Certains cas particuliers peuvent être discernés. Si q est parallèle à la direction [111], $Q_1 = Q_2 = Q_3 = 1/3$, et on en déduit $Q'_1 = Q'_2 = Q'_3 = 1/3$, c'est-à-dire que q' est aussi parallèle à [111] et donc confondu avec q, ce qui est impossible. On en déduit qu'un monocristal anisotrope du point de vue élastique ne peut pas adopter une direction de croissance de direction [111] dès lors qu'on fléchit le substrat 3. Ce résultat est valable quand le système de composantes (6) est utilisable, c'est-à-dire pour les cristaux à symétrie cubique ; il faut remarquer qu'en l'absence de flexion, la direction de croissance [111] est possible, de même que les directions de croissance [110] et [100].

Dans un deuxième cas particulier, on choisit $\beta_1$ et $\alpha$ de manière que $\beta = \beta_2$ Le système (10) donne comme solution $Q'_1 = Q'_2 = Q'_3 = 1/3$, et q est indéterminé. q' est donc de direction [111]. Le monocristal a un axe [111] parallèle à la direction $x_1$.

Dans un troisième cas, $\beta_1$ et $\alpha$ sont choisis de manière que $\beta = \beta_1$, on a réciproquement $Q''_1 = Q''_2 = Q''_3 = 1/3$, et q encore indéterminé. q" est donc de direction [111]. Le monocristal a un axe [111] parallèle à la direction $x_2$. Ces deux derniers exemples montrent que les cristaux peuvent être orientés en azimut autour de la direction $x_3$ orthogonale à la couche 4 d'après les choix de $\beta_1$ et $\alpha$.

Dans le cas d'une couche de cuivre ayant un coefficient de Poisson $\nu$ =0,33, des constantes élastiques $C_{11}$ - 169 GPa, $C_{12}$ = 122 GPa, $C_{44}$ = 76 GPa et un coefficient de dilatation thermique égal à $16.10^{-6}$ $K^{-1}$, si on fléchit le substrat de manière que $\beta_1 = 3.10^{-3}$, la condition $\beta = \beta_1$, du troisième cas particulier s'obtient pour $\alpha = 2,16.10^{-3}$ soit $\Delta T = +135$ °c et la condition $\beta_2$ du deuxième cas particulier pour $\alpha = -0,156.10^{-3}$ soit $\Delta T = -10$°C.

D'autres orientations en azimut peuvent être obtenues avec d'autres variations de température. Les résultats précédents ont été obtenus pour des situations où q1, q2 et q3 sont tous les trois non nuls. Le vecteur q pourrait avoir une ou deux composantes nulles, et des résultats similaires seraient encore obtenus. Si par exemple $q_3 = 0$ et $q_1 \neq q_2$, si on choisit $\beta 1$ et $\alpha$ de manière que $\beta = \beta_2$, q' est la direction [001] et q (1 q') est indifférent. L'axe [001] des cristaux est alors orienté dans la direction $x_1$. De même, si $\beta = \beta_1$, q" est de direction [001] et l'axe correspondant du cristal est dans la direction $x_2$.

Les résultats précédents peuvent être extrapolés à d'autres cristaux, les systèmes étant seulement plus compliqués puisque le tenseur d'élasticité a alors moins de composantes $C_{ij}$ nulles que le système (6). Par exemple, le tenseur d'un système monoclinique est donné par le système (11) :

$$\begin{pmatrix} C_{11} & C_{12} & C_{13} & 0 & C_{15} & 0 \\ C_{12} & C_{22} & C_{23} & 0 & C_{25} & 0 \\ C_{13} & C_{23} & C_{33} & 0 & C_{35} & 0 \\ 0 & 0 & 0 & C_{44} & 0 & C_{46} \\ C_{15} & C_{25} & C_{35} & 0 & C_{55} & 0 \\ 0 & 0 & 0 & C_{46} & 0 & C_{66} \end{pmatrix}$$

Dans tous les cas, il est possible d'orienter le réseau du cristal en azimut autour de la direction orthogonale à la couche cristalline d'après la température et la flexion correspondantes.

Le dispositif devrait couvrir une gamme de température assez large, typiquement entre l'ambiante et 500°C. Le banc de flexion 2 serait dimensionné pour induire des déformations de l'ordre de quelques millièmes. Le four 1 devrait être sous vide ou sous gaz neutre afin d'éviter l'oxydation des couches traitées.

## Revendications

1. Procédé de cristallisation consistant à déposer au moins partiellement la matière du cristal sur un substrat en une couche (4) mince telle que des déformations parallèles à une surface d'un substrat (3) sur laquelle la couche (4) est déposée sont intégralement communiquées à ladite couche sur toute son épaisseur, à porter le substrat et la matière déposée sur le substrat (3) à une première température pendant une durée permettant de relâcher des contraintes internes présentes dans la matière déposée, puis à soumettre le substrat et ladite matière déposée à une seconde température et à une flexion uniforme en plaçant le substrat sur un banc (2) de flexion, une quantité de flexion et une différence entre la première et la seconde température ayant des valeurs déterminées à partir de relations faisant intervenir des constantes élastiques ($C_{ij}$) de flexion, des déformations thermiques (x) et des coefficients de dilatation thermique pour favoriser une orientation cristallographique particulière de la matière déposée selon une direction d'azimut par rapport à une direction normale au substrat définie par le système

$$\begin{cases} \left(Q_1' - \dfrac{1}{3}\right)(\beta_1 - \beta_2) + \left(Q_1 - \dfrac{1}{3}\right)(\beta - \beta_2) = 0 \\[2mm] \left(Q_2' - \dfrac{1}{3}\right)(\beta_1 - \beta_2) + \left(Q_2 - \dfrac{1}{3}\right)(\beta - \beta_2) = 0 \\[2mm] \left(Q_3' - \dfrac{1}{3}\right)(\beta_1 - \beta_2) + \left(Q_3 - \dfrac{1}{3}\right)(\beta - \beta_2) = 0 \end{cases}$$

où $\beta 1$, $\beta 2$ et $\beta$ sont des déformations totales subies par la couche (4) dans des directions de longueur, correspondant à une courbure associée à la flexion, de largeur et d'épaisseur de la couche (4), et $Q_1$, $Q_2$, $Q_3$, $Q'_1$, $Q'_2$ et $Q'_3$ sont

égaux $q_1^2$, $q_2^2$, $q_3^2$, $q'^2_1$, $q'^2_2$ et $q'^2_3$, , où $q_1$, $q_2$ et $q_3$, et $q'_1$, $q'_2$ et $q'_3$ sont des coordonnées de vecteurs unitaires ($x_1$, $x_2$) orientés dans lesdites directions de longueur et de largeur, exprimées dans un repère ($y_1$, $y_2$, $y_3$) du cristal.

## Claims

1. Crystallisation method, consisting in depositing at least partially the material of the crystal or a substrate in a thin film (4) so that strains parallel to a surface of a substrate (3) on which the film (4) is deposited are integrally transmitted to said film in all the thickness thereof, heating the substrate and the material deposited on the substrate (3) to a first temperature for a time enabling internal stresses present in the deposited material to be relaxed, then subjecting the substrate and said deposited material to a second temperature sand to a uniform bending by placing the substrate on a bending bench (2), a quantity of bending and a difference between the first and the second temperature heaving values determined from relations bringing into play elastic bending constants ($C_{ij}$), thermal deformations (x) and thermal expansion coefficients to flavour a particular crystallographic orientation of the material deposited along an azimuth direction in relation to a direction normal to the substrate, which is defined by the system

$$\begin{cases} \left( Q'_1 - \frac{1}{3} \right)(\beta_1 - \beta_2) + \left( Q_1 - \frac{1}{3} \right)(\beta - \beta_2) = 0 \\ \left( Q'_2 - \frac{1}{3} \right)(\beta_1 - \beta_2) + \left( Q_2 - \frac{1}{3} \right)(\beta - \beta_2) = 0 \\ \left( Q'_3 - \frac{1}{3} \right)(\beta_1 - \beta_2) + \left( Q_3 - \frac{1}{3} \right)(\beta - \beta_2) = 0 \end{cases}$$

where $\beta_1$, $\beta_2$ and $\beta$ are total deformations underwent by the film (4) in length, corresponding to a curvature related to the bending, width and thickness directions in the film (4), and $Q_1$, $Q_2$, $Q_3$, $Q'_1$, $Q'_2$ and $Q'3$ are equal to $q_1^2$, $q_2^2$, $q_3^2$, $q'^2_1$, $q'^2_2$ and $q'^2_3$ where $q_1$, $q_2$ and $q_3$, and $q'_1$, $q'_2$ and $q'_3$ are coordinates of unitary vectors ($x_1$, $x_2$) oriented in said length and width directions, expressed in a reference ($y_1$, $y_2$, $y_3$) of the crystal.

## Patentansprüche

1. Kristallisationsverfahren, umfassend das zumindest teilweise Abscheiden eines kristallinen Materials auf einem Substrat in einer Schicht (4), die so dünn ist, dass parallel Verformungen einer Oberfläche des Substrats (3), auf welcher die Schicht (4) abgeschieden wird, vollständig auf die Schicht über ihre gesamte Dicke übertragen werden, um das Substrat und das auf einem Substrat (3) abgeschiedene Material bei einer ersten Temperatur während einer Zeitdauer zu tragen, die es erlaubt innere Spannungen zu entspannen, die in dem abgeschiedenen Material vorliegen, dann Aussetzen des Substrats und des abgeschiedenen Materials einer zweiten Temperatur und einer gleichförmigen Biegung durch Anordnung des Substrats auf eine Biegebank (2), ein Biegeausmaß und einen Unterschild zwischen der ersten und der zweiten Temperatur mit Werten, die ausgehend von Beziehungen bestimmt werden, die die Konstanten der elastischen Biegung ($C_{ij}$), thermische Verformungen (x) und Wärmeausdehnungskoeffizienten einsetzen zum Bevorzugen einer speziellen kristallographischen Orientierung von dem abgeschiedenen Material, entsprechend einer Azimut-Richtung, bezogen auf eine Normalrichtung des Substrats, definiert durch das System

$$\begin{cases} \left(Q_1' - \dfrac{1}{3}\right)(\beta_1 - \beta_2) + \left(Q_1 - \dfrac{1}{3}\right)(\beta - \beta_2) = 0 \\[2ex] \left(Q_2' - \dfrac{1}{3}\right)(\beta_1 - \beta_2) + \left(Q_2 - \dfrac{1}{3}\right)(\beta - \beta_2) = 0 \\[2ex] \left(Q_3' - \dfrac{1}{3}\right)(\beta_1 - \beta_2) + \left(Q_3 - \dfrac{1}{3}\right)(\beta - \beta_2) = 0 \end{cases}$$

worin $\beta1$, $\beta2$ und $\beta$ Gesamtverformungen sind, die die Schicht (4) erfährt in den Richtungen der Länge, entsprechend einer Krümmung, die mit der Biegung verbunden ist, der Breite und der Dicke der Schicht (4), und worin $Q_1$, $Q_2$, $Q_3$, $Q'_2$ und $Q'_3$ gleich $q_1^2$, $q_2^2$, $q_3^2$, $q'_1^2$, $q'_2^2$ und $q'_3^2$ sind, worin $q_1$, $q_2$ und $q_3$ und $q'_1$, $q'_2$ und $q'_3$ Koordinaten von Einheitsvektoren ($x_1$, $x_2$) sind, die in den Richtungen der Länge und Breite orientiert sind, ausgedrückt in einem Kristallkoordinatensystem ($y_1$, $y_2$, $y_3$).

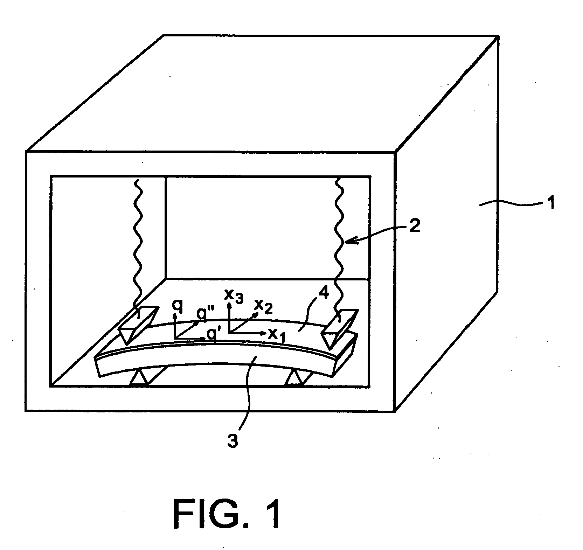

# FIG. 1

**EP 2 218 805 B1**

## RÉFÉRENCES CITÉES DANS LA DESCRIPTION

**Littérature non-brevet citée dans la description**

- **P. Besser et al.** Microstructural characterization of Inlaid copper Interconnect lines. *J. of Electr. Mat,* 2001, vol. 30, 320-330